# EUROPEAN PATENT APPLICATION

(11) **EP 3 584 841 A1**
(43) Date of publication of application: **25.12.2019**
(21) Application number: 19173125.6
(22) Date of filing: 07.05.2019
(51) Int. Cl.: H01L 29/423, H01L 21/285, H01L 29/778

(54) **METHODS OF TRANSISTOR GATE STRUCTURING USING SINGLE OPERATION DUMMY GATE REMOVAL**

(30) Priority: 20.06.2018 US 201816013860
(71) Applicant: INTEL Corporation, Santa Clara, CA 95054 (US)
(72) Inventor: RADOSAVLJEVIC, Marko, Portland, OR 97229 (US); THEN, Han Wui, Portland, OR 97229 (US); DASGUPTA, Sansaptak, Hillsboro, OR 97124 (US); FISCHER, Paul, Portland, OR 97229 (US); HAFEZ, Walid, Portland, OR 97229 (US)
(74) Representative: Goddar, Heinz J.

(57) **Abstract**

A transistor gate is disclosed. The transistor gate includes a first part above a substrate that has a first width and a second part above the first part that is centered with respect to the first part and that has a second width that is greater than the first width. The first part and the second part form a single monolithic T-gate structure.

## Description

### TECHNICAL FIELD

Embodiments of the disclosure pertain to transistor gate structuring and, in particular, transistor gate structuring using single operation dummy gate removal.

### BACKGROUND

Gallium nitride (GaN) transistors are candidates for use in future RF products such as 5G devices. Important features of transistors are gate length and gate structure. Gate length affects switching speed and gate structure (T-gate, field plate) affects gate resistance and device breakdown. T-gate transistors are a type of transistor used in RF applications. A T-gate can include a narrow gate part that is formed to contact or be in close proximity to the transistor channel and a wider gate part that is formed above the narrow gate part. The narrow gate part is designed to increase the speed of the transistor and the wider gate part is designed to lower the resistance of the gate.

In some approaches gate features such as gate length can be managed through lithography only. However, T-gate and field plate features require additional lithography and processing/metallization operations. Typically, T-gate fabrication involves lift-off techniques that are considered to be dirty by state-of-the-art CMOS fabrication standards. Recent approaches form the T-gate using a two cycle replacement-metal-gate (RMG) process. A disadvantage of such approaches is that because the T-gate is metalized in two cycles, an adhesive interface between the gate parts associated with the two cycles may be required to complete the formation of the gate. The adhesive interface between the two gate parts can increase gate resistance. Additional disadvantages of such approaches include cost (additional layers add to the cost), and manufacturability (as gate length is aggressively scaled).

### BRIEF DESCRIPTION OF THE DRAWINGS

FIG. 1 shows a transistor that includes a gate formed using a previous approach to forming gates having a T-gate structure.
FIG. 2 is an illustration of a transistor that has a gate with a T-gate structure that is formed according to an embodiment.
FIG. 3 is an illustration of a transistor that has a gate with a T-gate structure that is formed according to an embodiment.
FIGS. 4A-4F are illustrations of cross-sections of a semiconductor structure during a process of fabricating a transistor that has a gate with a T-gate structure according to an embodiment.
FIGS. 5A-5F are illustrations of cross-sections of a semiconductor structure during a process of fabricating a transistor that has a gate with a T-gate structure according to an embodiment.
FIG. 6 illustrates a computing device in accordance with an embodiment.
FIG. 7 illustrates an interposer that includes one or more embodiments.

### DESCRIPTION OF THE EMBODIMENTS

Radio frequency (RF) transistor gate structuring approaches using single operation dummy gate removal, are described. In the following description, numerous specific details are set forth, such as specific integration and material regimes, in order to provide a thorough understanding of embodiments of the present disclosure. It will be apparent to one skilled in the art that embodiments of the present disclosure may be practiced without these specific details. In other instances, well-known features, such as integrated circuit design layouts, are not described in detail in order to not unnecessarily obscure embodiments of the present disclosure. Furthermore, it is to be appreciated that the various embodiments shown in the Figures are illustrative representations and are not necessarily drawn to scale.

Certain terminology may also be used in the following description for the purpose of reference only, and thus are not intended to be limiting. For example, terms such as "upper", "lower", "above", and "below" refer to directions in the drawings to which reference is made. Terms such as "front", "back", "rear", and "side" describe the orientation and/or location of portions of the component within a consistent but arbitrary frame of reference which is made clear by reference to the text and the associated drawings describing the component under discussion. Such terminology may include the words specifically mentioned above, derivatives thereof, and words of similar import.

Some previous approaches to forming T-gates for transistors have proven inadequate because they involve metalizing the T-gates in two cycles, where an adhesive interface that is used to bind parts of the T-gates, that are respectively associated with each cycle, is required to complete the formation of the gate. The adhesive interface between the two gate parts adds undesirable resistance. Additional disadvantages of previous approaches include cost (additional layers add to the cost), and manufacturability (as gate length is aggressively scaled). A process and device that addresses the shortcomings of such previous approaches is disclosed herein. As part of the disclosed process, a gate metal fill for a T gate is performed in a single operation. In an embodiment, separate patterning operations can be used to create a dummy gate foot part and a dummy gate T part of a dummy gate that is used in the fabrication of the T gate. However, rather than replacing the dummy gate foot part, and the dummy gate T part in separate operations, both dummy gate parts are replaced in a single removal operation after the dummy gate T part has been formed.

In another embodiment, an intentionally designed offset between the dummy gate foot part and the dummy gate T part is used to facilitate a shorter gate length by defining a window through which a narrow gate portion is etched.

An advantage of embodiments is the provision of a process that enables a gate metal fill to be performed in a single operation such that the creation of a resistive interface between the foot part of the gate and the T part of the gate is avoided. Another advantage is that the process is compatible with state-of-the-art CMOS processing. Furthermore, embodiments simplify processes for fabricating complicated gate designs.

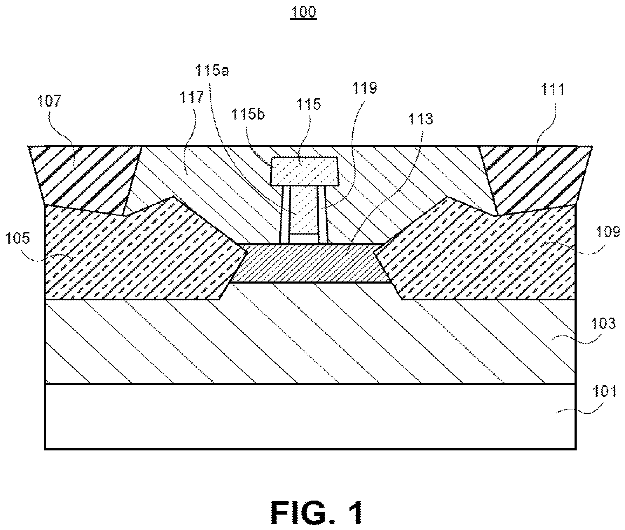

FIG. 1 is an illustration of a transistor fabricated using a previous approach to forming transistor gates having a T-gate structure. FIG. 1 shows substrate 101, epitaxial layer 103, source region 105, source contact 107, drain region 109, drain contact 111, polarization layer 113, gate 115, insulator 117 and high-k material 119.

Referring to FIG. 1, the gate 115 has a T-gate structure. In the approach of FIG. 1, the T-gate structure is formed in first and second cycles. In particular, the "foot" or bottom part of the gate 115a is formed in a first cycle and thereafter the "T" or top part of the gate 115b is formed in a second cycle to produce the T-shaped profile. The high-k material 119 lines the bottom and sides of the foot portion 115a of the gate 115. The high-k material 119 does not line the surface of the top part 115b of the gate 115.

In the FIG. 1 approach, as part of the formation of the gate 115, an adhesive metal is used at the interface between the bottom part of the gate 115a and the top part of the gate 115b. The adhesive metal can have a higher resistance than the metal (e.g., tungsten) that is used to form the bottom part 115a of the gate 115 and the top part 115b of the gate 115 and can increase the resistance of the gate 115. In addition, the adhesive material can oxidize which can increase the resistance of the gate 115.

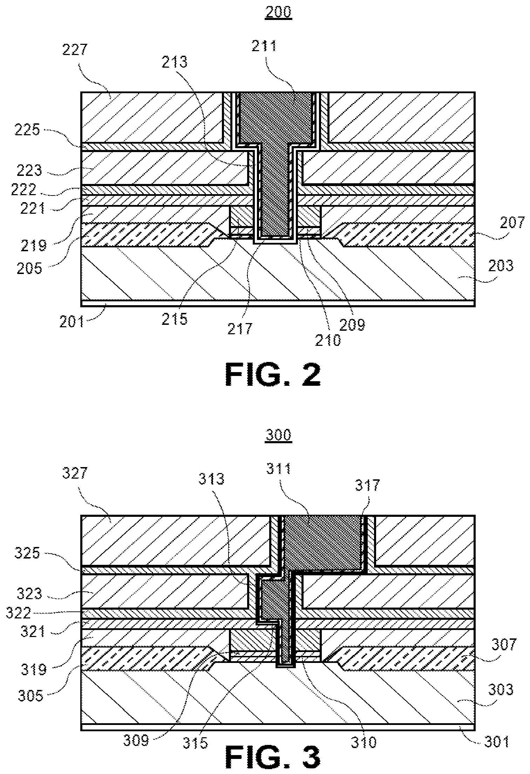

The manner in which the high-k material 119 is formed with respect to the gate 115 is an indicator that that the gate 115 is formed in two cycles. As discussed above, the high-k material 119 is formed only in the bottom part of the gate 115. Forming the gate in a single cycle requires that the space that the gate is to occupy be fully formed prior to filling. Where the space is fully formed, a deposition of conformal high-k material will line the entire surface of the space (as is described herein with reference to FIGS. 2 and 3) and not just the bottom portion of the space as is shown in FIG. 1. Using the two cycle approach, forming conformal high-k material in the top portion (e.g., the T part) of the space can result in an insulating interface between the bottom part 115a of the gate 115 and the top part 115b of the gate 115. To avoid this result, in the FIG. 1 approach, high-k material is not used to line the top portion of the space.

FIG. 2 is an illustration of a transistor 200 that has a gate with a T-gate structure that is formed according to an embodiment. FIG. 2 shows substrate 201, epitaxial layer 203, source region 205, drain region 207, adhesion layer 209, polarization layer 210, gate 211, high-k material 213, insulator 215, work function setting material 217, insulator 219, insulator 221, insulator 222, insulator 223, insulator 225, and insulator 227.

Referring to FIG. 2, the epitaxial layer 203 is formed on the substrate 201 which is the bottommost layer of the transistor 200. The source region 205 and the drain region 207 are formed on the epitaxial layer 203. The adhesion layer 209 is formed above the polarization layer 210. The polarization layer 210 is formed above the epitaxial layer 203. The gate 211 is formed in a trench that is lined with the high-k material 213 and the work function setting material 217. The insulator 219 is formed above the source region 205 and the drain region 207. The insulator 221 is formed above insulator 219. The insulator 222 is formed above insulator 221. The insulator 223 is formed above insulator 222. The insulator 225 is formed above the insulator 223. The insulator 227 is formed above the insulator 225.

In an embodiment, the substrate 201 can be formed from silicon. In other embodiments, the substrate 201 can be formed from other materials. In an embodiment, the epitaxial layer 203 can be formed from gallium nitride. In other embodiments, the epitaxial layer 203 can be formed from other materials. In an embodiment, the source region 205 and the drain region 207 can be formed from indium gallium nitride. In other embodiments the source region 205 and the drain region 207 can be formed from other materials. In an embodiment, the adhesion layer 209 is formed from silicon oxide. In other embodiments the adhesion layer 209 can be formed from other materials. In an embodiment, the polarization layer 210 can be formed from indium aluminum nitride. In other embodiments, the polarization layer 210 can be formed from other materials. In an embodiment the gate 211 can be formed from tungsten. In other embodiments the gate 211 can be formed from other materials. In an embodiment the high-k material 213 can be formed from an oxide such hafnium oxide, aluminum oxide or zirconium oxide. In other embodiments the high-k material 213 can be formed from other material. In an embodiment, the work function setting material 217 can be formed from titanium nitride or nickel. In other embodiments the work function setting material 217 can be formed from other materials. In an embodiment, the insulator 215 can be formed from a nitride. In other embodiments, the insulator 215 can be formed from other materials. In an embodiment, the insulator 222 and the insulator 225 can be formed from a nitride. In other embodiments, the insulator 222 and the insulator 225 can be formed from other materials. In an embodiment, the insulator 219, the insulator 223 and the insulator 227 can be formed from an oxide. In other embodiments, the insulator 219, the insulator 223 and the insulator 227 can be formed from other material. In an embodiment, the insulator 221 can be formed from silicon oxide. In other embodiments, the insulator 221 can be formed from other materials.

Referring to FIG. 2, the gate 211 has a T-shaped profile and is designed to have gate dimensions and gate resistance that establish operating parameters that maximize the performance capability of the transistor 200. The gate 211 is formed in a single cycle. More specifically, both the bottom part of the gate 211 and the top part of the gate 211 are formed in a single cycle to produce the T-shaped profile. As part of the process of forming the gate 211, a space is formed that has the dimensions that have been determined to provide a gate structure with desired electrical characteristics. In an embodiment, the space is shaped by bottom and top dummy gates. After the bottom dummy gate and the top dummy gate are in place and have been encapsulated in surrounding material, the bottom dummy gate and the top dummy gate are removed from the surrounding material such that a hollow space having the desired T-shaped profile is formed. In an embodiment, conformal layers of the high-k material 213 and the work function setting material 217 are formed on the bottom and sidewall surfaces of the space before it is filled with the selected gate metal. The gate that is produced is a monolithic structure that has a T-shaped profile with dimension and resistance characteristics that maximize performance.

The manner in which the high-k material 213 lines the surface of the space formed by the bottom dummy gate and the top dummy gate is an indicator that the gate 213 is formed in a single operation. In particular, the high-K material lines the entire surface of the space filled by the gate 213 (in contrast to FIG. 1). If the gate was formed in two cycles, in order to prevent high-k material from covering the top surface of a bottom gate part already in place, the application of high-k material to line the space above the bottom gate part would probably be avoided. In particular, in an embodiment, the fact that a fully formed space is available to enable a conformal high-k material to line both the gate foot and gate T parts of the space, indicates that a fully formed space is available thereafter for filling with the selected gate material. The gate material is applied over the high-k material to achieve single operation conversion of the gate into metal.

In operation, transistor 200 is turned on by applying a voltage to gate 211 that causes current to conduct in the channel between the source and the drain. In an embodiment, the gate 211 has a monolithic T-gate structure that provides reduced gate resistance. In addition, in an embodiment, significant charge is generated at the interface of the epitaxial layer 203 and the polarization layer 209 due to the intrinsic properties of the two materials. This charge is generated without doping or the application of an electric field. As a result, based on the properties of the two materials, a channel is provided between the source and the drain that has a low resistance. The lower gate resistance and channel resistance of transistor 200 impact parameters that are important to its RF performance such as input impedance, speed and noise.

FIG. 3 is an illustration of a transistor 300 that has a gate with a T-gate structure that is formed according to an embodiment. FIG. 3 shows substrate 301, epitaxial layer 303, source region 305, drain region 307, adhesion layer 309, polarization layer 310, gate 311, high-k material 313, insulator 315, work function setting layer 317, insulator 319, insulator 321, insulator 322, insulator 323, insulator 325 and insulator 327.

Referring to FIG. 3, the epitaxial layer 303 is formed on substrate 301 which is the bottommost layer of the transistor 300. The source region 305 and the drain region 307 are formed on the epitaxial layer 303. The adhesion layer 309 is formed above the polarization layer 310. The polarization layer 310 is formed above the epitaxial layer 303. The gate 311 is formed in a trench that is lined with the high-k material 313 and the work function setting material 317. The insulator 315 is formed above the adhesion layer 309. The insulator 319 is formed above the source region 305 and the drain region 307. The insulator 321 is formed above the insulator 319. The insulator 322 is formed above the insulator 321. The insulator 323 is formed above the insulator 322. The insulator 325 is formed above the insulator 323. The insulator 327 is formed above the insulator 325.

In an embodiment, the substrate 301 can be formed from silicon. In other embodiments, the substrate 301 can be formed from other materials. In an embodiment, the epitaxial layer 303 can be formed from gallium nitride. In other embodiments, the epitaxial layer 303 can be formed from other materials. In an embodiment, the source region 305 and the drain region 307 can be formed from indium gallium nitride. In other embodiments, the source region 305 and the drain region 307 can be formed from other materials. In an embodiment, the adhesion layer 309 is formed from silicon oxide. In other embodiments the adhesion layer can be formed from other materials. In an embodiment, the polarization layer 310 can be formed from indium aluminum nitride. In other embodiments, the polarization layer 310 can be formed from other materials. In an embodiment, the gate 311 can be formed from tungsten. In other embodiments, the gate 311 can be formed from other materials. In an embodiment, the high-k material 313 can be formed from an oxide such hafnium oxide, aluminum oxide or zirconium oxide. In other embodiments, the high-k material 313 can be formed from other materials. In an embodiment, the work function setting material 317 can be formed from titanium nitride or nickel. In other embodiments, the work function setting material 317 can be formed from other materials. In an embodiment, the insulator 315 can be formed from a nitride. In other embodiments, the insulator 315 can be formed from other materials. In an embodiment, the insulator 322 and the insulator 325 can be formed from a nitride. In other embodiments, the insulator 322 and the insulator 325 can be formed from other materials. In an embodiment, the insulator 319, the insulator 323 and the insulator 327 can be formed from an oxide. In other embodiments, the insulator 319, the insulator 323 and insulator the 327 can be formed from other materials. In an embodiment, the insulator 321 can be formed from silicon oxide. In other embodiments, the insulator 321 can be formed from other materials.

Referring to FIG. 3, the gate 311, similar to the gate 211 in FIG. 2, has a T-shaped profile that is designed to provide gate dimensions and gate resistance that establish operating parameters that enhance the performance capability of the transistor 300. In contrast to the embodiment of FIG. 2, the top part of the gate 311 is offset from the intermediate part of the gate 311. During the structuring of the space for the gate, the width of the opening that corresponds to the overlap of the top part of gate 311 and the intermediate part of gate 311 is used to control the width of an etch into the insulator 315 and the adhesion layer 309 that forms the space for the bottom part of the gate 311. Similar to the embodiment, of FIG. 2, the gate 311 is formed in a single cycle. In particular, the bottom part of the gate 311, the intermediate part of the gate 311 and the top part of the gate 311 are formed in a single metal fill operation to produce a gate having a T-shaped profile. As part of the process of forming the gate 311, after first and second dummy gates have been put into place and removed, a window is formed between the spaces that are created by the removal of the dummy gates, that has a width that is equal in size to the width that is desired for the bottom portion of the gate. Thereafter, the space for the bottom portion of the gate is etched using the window. Based on these operations, a space having the desired T-shaped profile is formed. After the space having the desired T-shaped profile has been formed, conformal layers of the high-k material 313 and the work function setting material 317 are formed on the bottom and sidewall surfaces of the space having the desired T-shaped profile, before it is filled with a gate metal. Thus, the gate that is produced is a monolithic structure having a T-shaped profile with dimension and resistance characteristics that maximize performance.

In an embodiment, gate length scaling is facilitated by the etch through the adhesion layer 309. As described above, the etch will affect an area of short length that corresponds to the place where spaces created to accommodate first and second layers of the gate overlap (the etch window). The etch window is created by intentionally designing an offset between the first and second gate layers. Each of the gate layers plays a role in the performance of the transistor. For example, the gate layer that is formed by the etch through the adhesion layer 309 enables scaling, the middle layer can be considered the T-gate layer that improves gate resistance, and the top layer can be used as a field plate.

In operation, transistor 300 is turned on by applying a voltage to gate 311 that causes current to conduct in the channel between the source and the drain. In an embodiment, the gate 311 has a monolithic T-gate structure that provides reduced gate resistance. In addition, in an embodiment, significant charge is generated at the interface of the epitaxial layer 303 and the adhesion layer 309 due to the intrinsic properties of the two materials. This charge is generated without doping or the application of an electric field. As a result, based on the properties of the two materials, a channel is provided between the source 305 and the drain 307 that has a low resistance. The low gate resistance and channel resistance of transistor 300 impact parameters that are important to its RF performance such as input impedance, speed and noise.

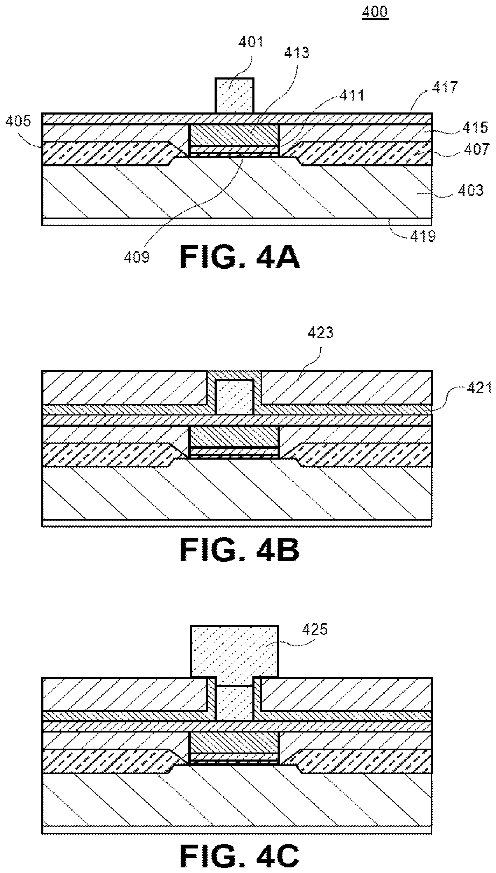

FIG. 4A-FIG. 4F are illustrations of cross-sections of a semiconductor structure in a process of fabricating a transistor having a gate with a T-gate profile.

Referring to FIG. 4A, after a plurality of operations, the cross-section of semiconductor structure 400 is produced that includes gate structure 401, epitaxial layer 403, source region 405, drain region 407, polarization layer 409, adhesion layer 411, isolation nitride 413, insulator 415, adhesion layer 417 and substrate 419.

Referring to FIG. 4B, after one or more operations that result in the cross-section in FIG. 4A, a conformal insulation layer 421 is formed on the top surface of the semiconductor structure covering the top and sides of the dummy gate 401. In addition, insulation layer 423 is formed to cover the conformal insulation layer 421 and the dummy gate 401. In an embodiment, the insulator 421 can be formed from silicon oxide. In other embodiments, the insulator 421 can be formed from other materials. In an embodiment, the insulator 423 can be formed from an oxide. In other embodiments, the insulator 421 can be formed from other materials.

Referring to FIG. 4C, after one or more operations that result in the cross-section shown in FIG. 4B, the part of the conformal insulator material 421 above the dummy gate part 401 is removed, and a patterning of the second dummy gate part 425 is performed. The patterning of the second dummy gate part 425 is performed after material for the dummy gate is formed on the surface of semiconductor structure 400.

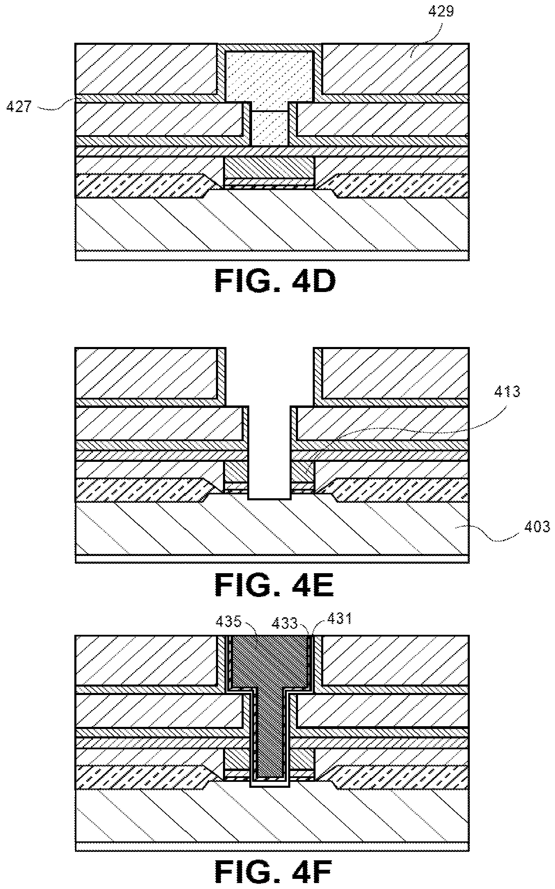

Referring to FIG. 4D, after one or more operations that result in the cross-section shown in FIG. 4C, conformal insulator material 427 is formed above the top surface of the second dummy gate part 425. In addition, insulator material 429 is formed above conformal insulator material 427 and polished to expose the top surface of the conformal insulator material 427 that is formed above dummy gate part 425. In an embodiment, the conformal insulator material 427 is formed from silicon nitride. In other embodiments, conformal insulator material 427 can be formed from other materials. In an embodiment, the insulator material 429 is formed from an oxide. In other embodiments, conformal insulator material 429 can be formed from other materials.

Referring to FIG. 4E, after one or more operations that result in the cross-section shown in FIG. 4D, both dummy gate parts are removed, and an etch through the isolation nitride layer 413 into epitaxial layer 403 is performed.

Referring to FIG. 4F, after one or more operations that result in the cross-section shown in FIG. 4E, the space formed after the removal of the dummy layers is lined with high-K material 431 and work function setting material 433 and is filled with gate conductor 435. Thus, a single operation "conversion" to gate conductor is provided. In an embodiment, the high-K material 431 can include oxide. In other embodiments, the high-K material 431 can include other materials. In an embodiment, work function setting material can include a work function setting metal. In other embodiments, the work function setting material can include other work function setting materials.

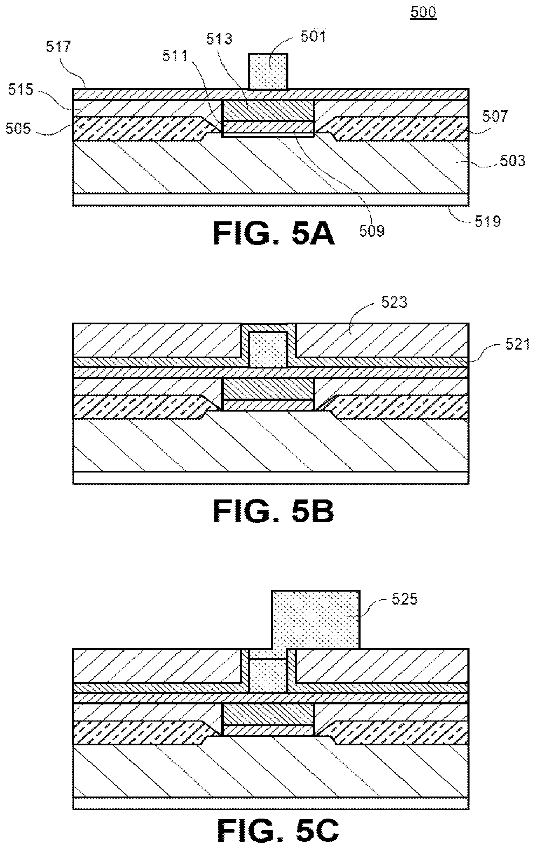

FIG. 5A-FIG. 5F are illustrations of cross-sections of a semiconductor structure in a process of fabricating a transistor having a gate with a T-gate profile.

Referring to FIG. 5A, after a plurality of operations, the cross-section of semiconductor structure 500 is produced that includes gate structure 501, epitaxial layer 503, source region 505, drain region 507, polarization layer 509, adhesion layer 511, isolation nitride 513, insulator 515, insulator 517 and substrate 519.

Referring to FIG. 5B, after one or more operations that result in the cross-section shown in FIG. 5A, conformal insulator material 521 is formed on the top surface of the semiconductor structure 500 and covers the top and sides of the dummy gate 501. In addition, insulator material 523 is formed above the conformal insulator material 521 and is polished to expose the top portion of the conformal insulator material 521 that is formed above the dummy gate. In an embodiment, the conformal insulator material 521 is formed from silicon nitride. In other embodiments, conformal insulator material 521 can be formed from other materials.

Referring to FIG. 5C, after one or more operations that result in the cross-section shown in FIG. 5B, the part of the conformal insulator layer 521 above the dummy gate part 501 is removed, and a patterning of a second dummy gate part 525 is performed. The second dummy gate part 525 is patterned such that the center of the second dummy gate part 525 is offset from the center of the first dummy gate part 501 by a predetermined amount. In addition, the second dummy gate part 525 is patterned such that a small overlapping region between the first dummy gate part 501 and the second dummy gate part 525 is provided.

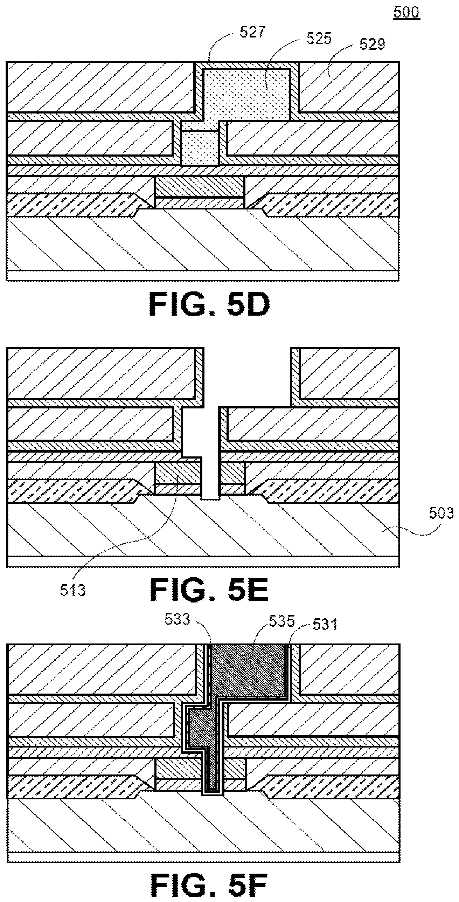

Referring to FIG. 5D, after one or more operations that result in the cross-section shown in FIG. 5C, insulator material 527 is formed to cover the top surface of the semiconductor structure 500. In addition, insulator material 529 is formed above insulator material 527 and polished to expose the top a portion of the top surface of insulator material 527 that is formed above dummy gate part 525. In an embodiment, the conformal insulator material 527 is formed from silicon nitride. In other embodiments, conformal insulator material 527 can be formed from other materials. In an embodiment, the insulator material 529 is formed from an oxide. In other embodiments, the insulator material 529 can be formed from other materials.

Referring to FIG. 5E, after one or more operations that result in the cross-section shown in FIG. 5D, both dummy layers are removed. The removal of the dummy layers creates spaces in the places previously occupied by the dummy layers and an opening in the overlapping region between the spaces. This opening or window is used to perform an etch through the nitride layer 513 into epitaxial layer 503. The width of the etch through the nitride layer 513 corresponds to the width of the etch window.

Referring to FIG. 5F, after one or more operations that result in the cross-section shown in FIG. 5E, the space formed after the removal of the dummy layers is lined with high-K material 531 and work function setting material 533. The remaining space is then filled with gate conductor material 535. In an embodiment, the high-K material 531 can include an oxide. In other embodiments, the high-K material 531 can include other materials. In an embodiment, work function setting material 533 can include a work function setting metal. In other embodiments, the work function setting material can include other work function setting materials.

Implementations of embodiments of the invention may be formed or carried out on a substrate, such as a semiconductor substrate. In one implementation, the semiconductor substrate may be a crystalline substrate formed using a bulk silicon or a silicon-on-insulator substructure. In other implementations, the semiconductor substrate may be formed using alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-V or group IV materials. Although a few examples of materials from which the substrate may be formed are described here, any material that may serve as a foundation upon which a semiconductor device may be built falls within the spirit and scope of the present invention.

A plurality of transistors, such as metal-oxide-semiconductor field-effect transistors (MOSFET or simply MOS transistors), may be fabricated on the substrate. In various implementations of the invention, the MOS transistors may be planar transistors, nonplanar transistors, or a combination of both. Nonplanar transistors include FinFET transistors such as double-gate transistors and tri-gate transistors, and wrap-around or all-around gate transistors such as nanoribbon and nanowire transistors. Although the implementations described herein may illustrate only planar transistors, it should be noted that the invention may also be carried out using nonplanar transistors.

Each MOS transistor includes a gate stack formed of at least two layers, a gate dielectric layer and a gate electrode layer. The gate dielectric layer may include one layer or a stack of layers. The one or more layers may include silicon oxide, silicon dioxide (SiO₂) and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric layer include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric layer to improve its quality when a high-k material is used.

The gate electrode layer is formed on the gate dielectric layer and may consist of at least one P-type workfunction metal or N-type workfunction metal, depending on whether the transistor is to be a PMOS or an NMOS transistor. In some implementations, the gate electrode layer may consist of a stack of two or more metal layers, where one or more metal layers are workfunction metal layers and at least one metal layer is a fill metal layer.

For a PMOS transistor, metals that may be used for the gate electrode include, but are not limited to, ruthenium, palladium, platinum, cobalt, nickel, and conductive metal oxides, e.g., ruthenium oxide. A P-type metal layer will enable the formation of a PMOS gate electrode with a workfunction that is between about 4.9 eV and about 5.2 eV. For an NMOS transistor, metals that may be used for the gate electrode include, but are not limited to, hafnium, zirconium, titanium, tantalum, aluminum, alloys of these metals, and carbides of these metals such as hafnium carbide, zirconium carbide, titanium carbide, tantalum carbide, and aluminum carbide. An N-type metal layer will enable the formation of an NMOS gate electrode with a workfunction that is between about 3.9 eV and about 4.2 eV.

In some implementations, the gate electrode may consist of a "U"-shaped structure that includes a bottom portion substantially parallel to the surface of the substrate and two sidewall portions that are substantially perpendicular to the top surface of the substrate. In another implementation, at least one of the metal layers that form the gate electrode may simply be a planar layer that is substantially parallel to the top surface of the substrate and does not include sidewall portions substantially perpendicular to the top surface of the substrate. In further implementations of the invention, the gate electrode may consist of a combination of U-shaped structures and planar, non-U-shaped structures. For example, the gate electrode may consist of one or more U-shaped metal layers formed atop one or more planar, non-U-shaped layers.

In some implementations of the invention, a pair of sidewall spacers may be formed on opposing sides of the gate stack that bracket the gate stack. The sidewall spacers may be formed from a material such as silicon nitride, silicon oxide, silicon carbide, silicon nitride doped with carbon, and silicon oxynitride. Processes for forming sidewall spacers are well known in the art and generally include deposition and etching process steps. In an alternate implementation, a plurality of spacer pairs may be used, for instance, two pairs, three pairs, or four pairs of sidewall spacers may be formed on opposing sides of the gate stack.

As is well known in the art, source and drain regions are formed within the substrate adjacent to the gate stack of each MOS transistor. The source and drain regions are generally formed using either an implantation/diffusion process or an etching/deposition process. In the former process, dopants such as boron, aluminum, antimony, phosphorous, or arsenic may be ion-implanted into the substrate to form the source and drain regions. An annealing process that activates the dopants and causes them to diffuse further into the substrate typically follows the ion implantation process. In the latter process, the substrate may first be etched to form recesses at the locations of the source and drain regions. An epitaxial deposition process may then be carried out to fill the recesses with material that is used to fabricate the source and drain regions. In some implementations, the source and drain regions may be fabricated using a silicon alloy such as silicon germanium or silicon carbide. In some implementations the epitaxially deposited silicon alloy may be doped in situ with dopants such as boron, arsenic, or phosphorous. In further embodiments, the source and drain regions may be formed using one or more alternate semiconductor materials such as germanium or a group III-V material or alloy. And in further embodiments, one or more layers of metal and/or metal alloys may be used to form the source and drain regions.

One or more interlayer dielectrics (ILD) are deposited over the MOS transistors. The ILD layers may be formed using dielectric materials known for their applicability in integrated circuit structures, such as low-k dielectric materials. Examples of dielectric materials that may be used include, but are not limited to, silicon dioxide (SiO2), carbon doped oxide (CDO), silicon nitride, organic polymers such as perfluorocyclobutane or polytetrafluoroethylene, fluorosilicate glass (FSG), and organosilicates such as silsesquioxane, siloxane, or organosilicate glass. The ILD layers may include pores or air gaps to further reduce their dielectric constant.

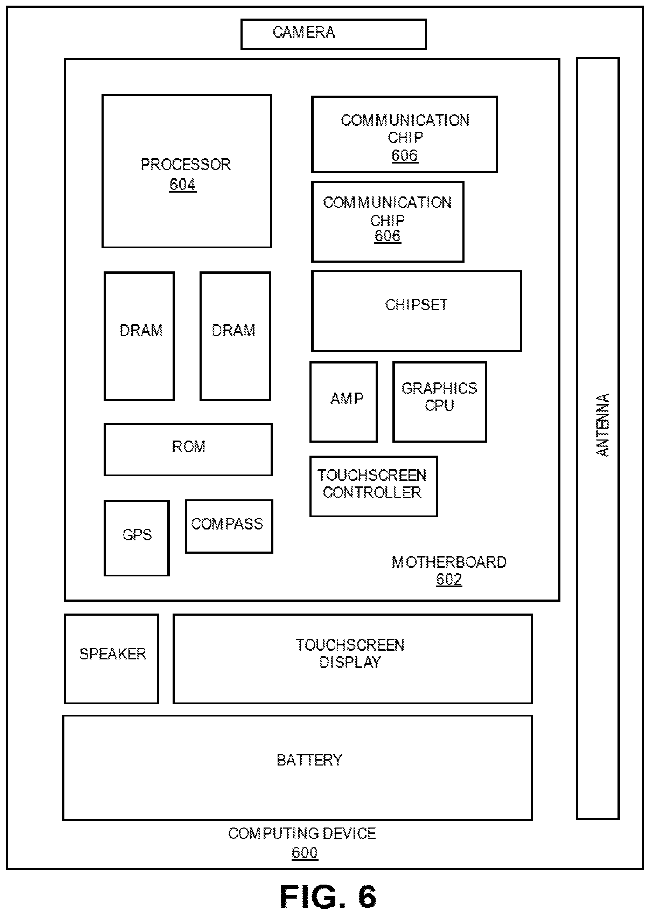

FIG. 6 illustrates a computing device 600 in accordance with one implementation of the invention. The computing device 600 houses a board 602. The board 602 may include a number of components, including but not limited to a processor 604 and at least one communication chip 606. The processor 604 is physically and electrically coupled to the board 602. In some implementations the at least one communication chip 606 is also physically and electrically coupled to the board 602. In further implementations, the communication chip 606 is part of the processor 604.

Depending on its applications, computing device 600 may include other components that may or may not be physically and electrically coupled to the board 602. These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 606 enables wireless communications for the transfer of data to and from the computing device 600. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 606 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 600 may include a plurality of communication chips 606. For instance, a first communication chip 606 may be dedicated to shorter range wireless communications such as Wi-Fi and Bluetooth and a second communication chip 606 may be dedicated to longer range wireless communications such as GPS, EDGE, GPRS, CDMA, WiMAX, LTE, Ev-DO, and others.

The processor 604 of the computing device 600 includes an integrated circuit die packaged within the processor 604. In some implementations of the invention, the integrated circuit die of the processor includes one or more devices, such as MOS-FET transistors built in accordance with implementations of the invention. The term "processor" may refer to any device or portion of a device that processes electronic data from registers and/or memory to transform that electronic data into other electronic data that may be stored in registers and/or memory.

The communication chip 606 also includes an integrated circuit die packaged within the communication chip 606. In accordance with another implementation of the invention, the integrated circuit die of the communication chip includes one or more devices, such as MOS-FET transistors built in accordance with implementations of the invention.

In further implementations, another component housed within the computing device 600 may contain an integrated circuit die that includes one or more devices, such as MOS-FET transistors built in accordance with implementations of the invention.

In various implementations, the computing device 600 may be a laptop, a netbook, a notebook, an ultrabook, a smartphone, a tablet, a personal digital assistant (PDA), an ultra mobile PC, a mobile phone, a desktop computer, a server, a printer, a scanner, a monitor, a set-top box, an entertainment control unit, a digital camera, a portable music player, or a digital video recorder. In further implementations, the computing device 600 may be any other electronic device that processes data.

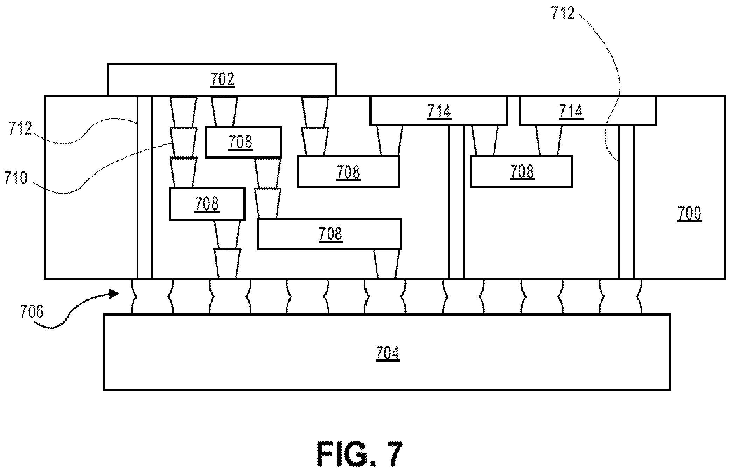

FIG. 7 illustrates an interposer 700 that includes one or more embodiments of the invention. The interposer 700 is an intervening substrate used to bridge a first substrate 702 to a second substrate 704. The first substrate 702 may be, for instance, an integrated circuit die. The second substrate 704 may be, for instance, a memory module, a computer motherboard, or another integrated circuit die. Generally, the purpose of an interposer 700 is to spread a connection to a wider pitch or to reroute a connection to a different connection. For example, an interposer 700 may couple an integrated circuit die to a ball grid array (BGA) 706 that can subsequently be coupled to the second substrate 704. In some embodiments, the first and second substrates 702/704 are attached to opposing sides of the interposer 700. In other embodiments, the first and second substrates 702/704 are attached to the same side of the interposer 700. And in further embodiments, three or more substrates are interconnected by way of the interposer 700.

The interposer 700 may be formed of an epoxy resin, a fiberglass-reinforced epoxy resin, a ceramic material, or a polymer material such as polyimide. In further implementations, the interposer may be formed of alternate rigid or flexible materials that may include the same materials described above for use in a semiconductor substrate, such as silicon, germanium, and other group III-V and group IV materials.

The interposer may include metal interconnects 708 and vias 710, including but not limited to through-silicon vias (TSVs) 712. The interposer 700 may further include embedded devices 714, including both passive and active devices. Such devices include, but are not limited to, capacitors, decoupling capacitors, resistors, inductors, fuses, diodes, transformers, sensors, and electrostatic discharge (ESD) devices. More complex devices such as radio-frequency (RF) devices, power amplifiers, power management devices, antennas, arrays, sensors, and MEMS devices may also be formed on the interposer 700. In accordance with embodiments of the invention, apparatuses or processes disclosed herein may be used in the fabrication of interposer 700.

Although specific embodiments have been described above, these embodiments are not intended to limit the scope of the present disclosure, even where only a single embodiment is described with respect to a particular feature. Examples of features provided in the disclosure are intended to be illustrative rather than restrictive unless stated otherwise. The above description is intended to cover such alternatives, modifications, and equivalents as would be apparent to a person skilled in the art having the benefit of the present disclosure.

The scope of the present disclosure includes any feature or combination of features disclosed herein (either explicitly or implicitly), or any generalization thereof, whether or not it mitigates any or all of the problems addressed herein. Accordingly, new claims may be formulated during prosecution of the present application (or an application claiming priority thereto) to any such combination of features. In particular, with reference to the appended claims, features from dependent claims may be combined with those of the independent claims and features from respective independent claims may be combined in any appropriate manner and not merely in the specific combinations enumerated in the appended claims.

The following examples pertain to further embodiments. The various features of the different embodiments may be variously combined with some features included and others excluded to suit a variety of different applications.

Example embodiment 1: A transistor gate includes a first part above a substrate that has a first width and a second part above the first part that is centered with respect to the first part and that has a second width that is greater than the first width. The first part and the second part form a single monolithic T-gate structure.

Example embodiment 2: The transistor gate of example embodiment 1, wherein the transistor gate is surrounded by a high-k material.

Example embodiment 3: The transistor gate of example embodiment 1, wherein the transistor gate is surrounded by work function setting material.

Example embodiment 4: The transistor gate of example embodiment 1, wherein the first part is formed above a gallium epitaxial layer.

Example embodiment 4: The transistor gate of example embodiment 1, wherein the first part extends through a polarization layer.

Example embodiment 6: The transistor gate of example embodiment 1, wherein the first part extends through an isolation layer.

Example embodiment 7: The transistor gate of example embodiment 1, 2, 3, 4, 5 or 6 wherein the first part extends through an adhesion layer.

Example embodiment 8: A transistor gate comprises a first part that has a first width, a second part that has a second width that is greater than the first width and a third part that has a third width that is greater than the second width. The first part, the second part and the third part form a single monolithic T-gate structure.

Example embodiment 9: The transistor gate of example embodiment 8, wherein a center of the third part is offset by a predetermined amount from the center of the second part.

Example embodiment 10: The transistor gate of example embodiment 8, wherein the transistor gate is surrounded by work function setting material.

Example embodiment 11: The transistor gate of example embodiment 8, wherein the first part is formed above a gallium nitride epitaxial layer.

Example embodiment 12: The transistor gate of example embodiment 8, wherein the first part extends through a polarization layer.

Example embodiment 13: The transistor gate of example embodiment 8, wherein the first part extends through an isolation layer.

Example embodiment 14: The transistor gate of example embodiment 8, 9, 10, 11, 12 or 13 wherein the first part extends through an adhesion layer.

Example embodiment 15: A method for forming a transistor gate comprises forming a dummy gate base part that has a first width in first material above a semiconductor substrate, forming a dummy gate top part that has a second width that is greater than the first width that extends into second material and removing the dummy gate base part and the dummy gate top part. The method further comprises forming a T-gate that has a monolithic structure in the space formed from the removal of the dummy gate base part and the dummy gate top part.

Example embodiment 16: The method of example embodiment 15, wherein the dummy gate base part and the dummy gate top part are coaxial.

Example embodiment 17: The method of example embodiment 15, further comprising forming a work function setting material around the T-gate.

Example embodiment 18: The method of example embodiment 15, further comprising forming the T-gate above a GaN epitaxial layer.

Example embodiment 19: The method of example embodiment 15, further comprising forming the T-gate to extend through a polarization layer.

Example embodiment 20: The method of example embodiment 15, 16, 17, 18 or 19 further comprising forming the T-gate to extend through an isolation layer.

## Claims

1. A transistor gate, the transistor gate comprising:
a first part above a substrate that has a first width; and
a second part above the first part that is centered with respect to the first part and that has a second width that is greater than the first width, wherein the first part and the second part form a single monolithic T-gate structure.

2. The transistor gate of claim 1, wherein the transistor gate is surrounded by a high-k material.

3. The transistor gate of claim 1 or 2, wherein the transistor gate is surrounded by a work function setting material.

4. The transistor gate of claim 1, 2 or 3, wherein the first part is formed above a gallium nitride epitaxial layer.

5. The transistor gate of claim 1, 2, 3 or 4, wherein the first part extends through a polarization layer.

6. The transistor gate of claim 1, 2, 3, 4 or 5, wherein the first part extends through an isolation layer.

7. The transistor gate of claim 1, 2, 3, 4, 5 or 6, wherein the first part extends through an adhesion layer.

8. A method for forming a transistor gate, the method comprising:
forming a dummy gate base part that has a first width in first material above a semiconductor substrate;
forming a dummy gate top part that has a second width that is greater than the first width that extends into second material;
removing the dummy gate base part and the dummy gate top part;
forming a T-gate that has a monolithic structure in the space formed from the removal of the dummy gate base part and the dummy gate top part.

9. The method of claim 8, wherein the dummy gate base part and the dummy gate top part are coaxial.

10. The method of claim 8 or 9, further comprising forming a work function setting material around the T-gate.

11. The method of claim 8, 9 or 10, further comprising forming the T-gate above a GaN epitaxial layer.

12. The method of claim 8, 9, 10 or 11, further comprising forming the T-gate to extend through a polarization layer.

13. The method of claim 8, 9, 10, 11 or 12, further comprising forming the T-gate to extend through an isolation layer.
